# FASCICULE DE BREVET EUROPEEN

(11) **EP 3 419 036 B1**
(45) Date de publication et mention de la délivrance du brevet: **19.06.2019**
(21) Numéro de dépôt: 18172146.5
(22) Date de dépôt: 14.05.2018
(51) Int. Cl.: H01H 3/02, H02B 1/044, H01H 13/50

(54) **DISPOSITIF DE FIXATION POUR ORGANE DE COMMANDE ET/OU DE SIGNALISATION ÉLECTRIQUE**
BEFESTIGUNGSVORRICHTUNG FÜR ELEKTRISCHES STEUER- UND/ODER ANZEIGEORGAN
ATTACHMENT DEVICE FOR ELECTRIC CONTROL AND/OR SIGNALLING MEMBER

(30) Priorité: 21.06.2017 FR 1755638
(43) Date de publication de la demande: 26.12.2018
(73) Titulaire: Schneider Electric Industries SAS, 92500 Rueil-Malmaison (FR)
(72) Inventeur: THIZON, Patrice, 16600 Ruelle sur Touvre (FR); FRANC, Maëlle, 92506 Rueil Malmaison Cedex (FR)
(74) Mandataire: Dufresne, Thierry

(56) Documents cités:
- EP-A1- 0 889 564
- WO-A2-2012/089195
- DE-B- 1 114 880

## Description

### Domaine technique de l'invention

La présente invention se rapporte à un dispositif de fixation pour organe de commande et/ou de signalisation électrique.

### Etat de la technique

Un organe de commande et/ou de signalisation électrique se présente généralement sous la forme d'un bouton poussoir, d'un bouton tournant, d'un bouton d'arrêt d'urgence, d'un voyant de signalisation ou d'une combinaison d'un bouton et d'un voyant.

Il comporte classiquement une tête et un corps tubulaire. Il est destiné à être monté dans une ouverture formée à travers une paroi, par exemple celle de la porte d'une armoire électrique ou d'un pupitre de commande.

Lors du montage de l'organe sur la paroi, le corps tubulaire est engagé à travers l'ouverture faite dans la paroi et la tête vient en appui contre une face avant de la paroi. Un dispositif de fixation permet ensuite d'assurer la fixation de l'organe en exerçant un appui opposé contre la face arrière de la paroi.

Le brevet EP0889564B1 décrit notamment un dispositif de fixation d'un tel organe de commande.

En référence à la figure 1, ce dispositif de fixation tel que décrit dans le brevet EP08889564B1 comporte principalement :
- Une embase montée sur le corps tubulaire de l'organe, par l'intermédiaire d'un verrou ;
- Une bride montée pivotante sur l'embase et une vis de serrage pour contrôler le pivotement de la bride.

Au moins un bloc de contacts et/ou d'éclairage fixé sur l'embase est destiné à assurer la commande d'un circuit électrique.

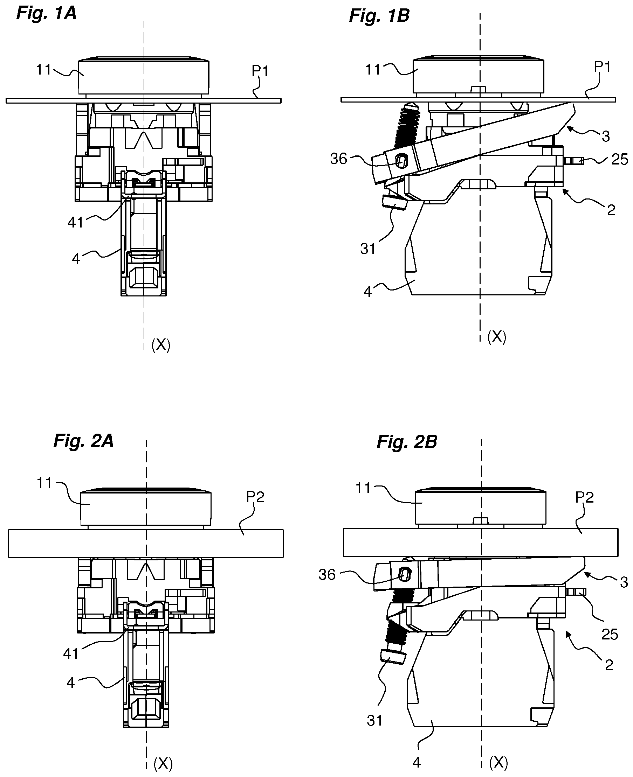

Sur cette figure 1, le dispositif de fixation est associé à un organe de commande de type bouton-poussoir et un bloc de contacts et/ou d'éclairage est fixé sur l'embase.

Plus récemment, il a été proposé d'améliorer la compacité et de réduire l'encombrement en profondeur d'un ensemble tel que décrit dans le brevet EP0889956B1**,** c'est-à-dire de l'ensemble formé par l'organe de commande, du dispositif de fixation et dudit au moins un bloc de contacts et/ou d'éclairage.

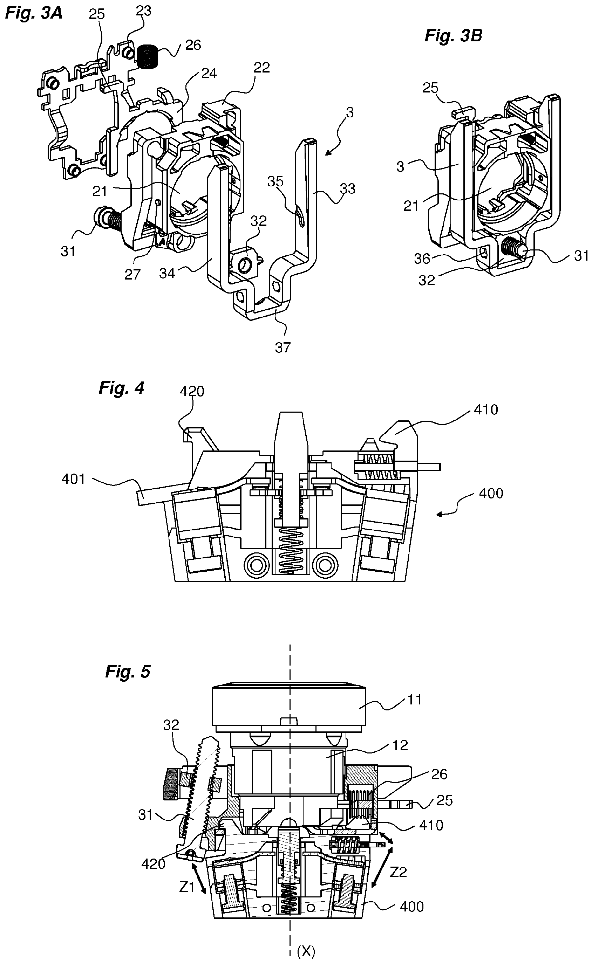

La figure 5 représente un ensemble utilisant un bloc de contacts et/ou d'éclairage plus compact. Dans cette architecture, on peut voir que l'association d'un bloc de contacts et/ou d'éclairage plus compact et du dispositif de fixation connu du brevet EP0889956B1 crée des lignes de fuite, notamment entre le bloc de contacts et/ou d'éclairage, l'embase du dispositif de fixation et les câbles. Des lignes de fuites sont ainsi créées notamment :
- Entre la tête de la vis de serrage et les sorties de câble au niveau du bloc de contacts et/ou d'éclairage ;
- Entre le verrou de fixation métallique de chaque bloc de contacts et/ou d'éclairage sur l'embase et les sorties de câble au niveau du bloc de contacts et/ou d'éclairage.

Il en ressort qu'un tel bloc de contacts et/ou d'éclairage plus compact ne peut être associé sans modification, au dispositif de fixation classique et intégré dans un ensemble connu du brevet antérieur EP0889956B1.

Le but de l'invention est donc de proposer un nouveau dispositif de fixation pour organe de commande et/ou de signalisation qui puisse être compatible avec l'utilisation de bloc de contacts et/ou d'éclairage plus compact, afin de ne pas générer des lignes de fuite.

### Exposé de l'invention

Ce but est atteint par un dispositif de fixation pour organe de commande et/ou de signalisation électrique destiné à être assemblé suivant un axe principal à travers une ouverture réalisée dans une paroi et comportant une tête destinée à venir en appui contre une première face de la paroi et un corps tubulaire destiné à être engagée à travers l'ouverture, ledit dispositif de fixation comportant :
- une embase destinée à porter au moins un bloc de contacts électriques et/ou d'éclairage,
- une bride de fixation montée pivotante sur l'embase autour d'un premier axe,
- ladite bride comportant au moins une branche dotée d'une extrémité libre destinée à former au moins un premier point d'appui contre une deuxième face de la paroi opposée à ladite première face,
- un élément articulé autour d'un deuxième axe et coopérant avec ladite bride pour l'entraîner en pivotement autour dudit premier axe,
- une vis de serrage guidée dans ladite embase et coopérant avec ladite articulation pour contrôler le pivotement de ladite bride et comprenant une extrémité formant au moins un deuxième point d'appui contre ladite deuxième face de la paroi,
- la bride étant configurée de manière à ce qu'un premier plan incluant ledit premier axe et ledit deuxième axe et un deuxième plan incluant ledit premier axe et ledit premier point d'appui formant un angle compris entre 110° et 160°.

Selon une réalisation particulière, ledit angle est compris entre 120° et 150°.

Selon une réalisation particulière, l'embase comporte un corps et une platine porte-contacts et ladite platine porte-contacts est réalisée en matériau plastique.

Selon une réalisation particulière, la bride comporte une forme en étrier possédant deux branches reliées entre elles par un pont.

Selon une réalisation particulière, les deux branches présentent chacune au moins un profil incurvé.

Selon une réalisation particulière, ledit élément articulé comporte une plaquette-écrou articulée par rapport à l'embase.

L'invention concerne également un ensemble de commande et/ou de signalisation électrique comprenant :
- un organe de commande et/ou de signalisation électrique destiné à être assemblé suivant un axe principal à travers une ouverture réalisée dans une paroi et comportant une tête destinée à venir en appui contre une première face de la paroi et un corps tubulaire destiné à être engagée à travers l'ouverture,
- un dispositif de fixation tel que défini ci-dessus.

Selon une réalisation particulière, l'ensemble de commande et/ou de signalisation électrique comporte au moins un bloc de contacts et/ou d'éclairage fixé sur l'embase dudit dispositif de fixation.

Selon une réalisation particulière, le bloc de contacts et/ou d'éclairage comporte au moins un boîtier présentant une proéminence agencée pour assurer un allongement de la ligne de fuite entre au moins une sortie de câble dudit bloc de contacts et/ou d'éclairage et un verrou de fixation métallique dudit bloc de contacts et/ou d'éclairage sur ladite embase.

### Brève description des figures

D'autres caractéristiques et avantages vont apparaître dans la description détaillée qui suit, faite en liaison avec les dessins annexés listés ci-dessous :
- Les figures 1A et 1B représentent un ensemble de commande selon l'état de la technique monté sur un panneau d'épaisseur 1 mm ;
- Les figures 2A et 2B représentent un ensemble de commande selon l'état de la technique monté sur un panneau d'épaisseur 6 mm ;
- Les figures 3A et 3B représentent le dispositif de fixation tel qu'employé dans l'état de la technique, respectivement en vue éclaté et en vue assemblé ;
- La figure 4 représente un bloc de contacts et/ou d'éclairage de type compact ;
- La figure 5 représente un ensemble de commande selon l'état de la technique employant un bloc de contacts et/ou d'éclairage compact tel que représenté sur la figure 4 ;
- Les figures 6A et 6B représentent un ensemble de commande monté sur un panneau d'épaisseur 1 mm à l'aide d'un dispositif de fixation conforme à l'invention ;
- Les figures 7A et 7B représentent un ensemble de commande monté sur un panneau d'épaisseur 6 mm à l'aide d'un dispositif de fixation conforme à l'invention ;
- La figure 8 représente, vu en éclaté, le dispositif de fixation de l'invention ;
- Les figures 9A et 9B représentent respectivement le dispositif de fixation de l'invention et le dispositif de fixation de l'état de la technique ;
- Les figures 10A et 10B illustrent un ensemble de commande, respectivement selon l'état de la technique et selon l'invention et illustrent le gain en compacité obtenu.

### Description détaillée d'au moins un mode de réalisation

Dans la suite de la description, les termes "avant" et "arrière" sont à comprendre en prenant comme référence la paroi de fixation d'un organe de commande et/ou de signalisation.

Pour la suite de la description, on définit un axe principal (X) correspondant à l'axe suivant lequel un organe de commande et/ou de signalisation est engagé à travers une paroi pour son montage.

De manière non limitative, un organe de commande et/ou de signalisation correspond à un bouton poussoir, un bouton tournant, un bouton d'arrêt d'urgence ou un voyant de visualisation.

Avec son dispositif de fixation et un ou plusieurs blocs de contact, l'organe de commande et/ou de signalisation forme un ensemble de commande et/ou de signalisation.

De manière non limitative, en liaison avec les dessins annexées, la suite de la description est réalisée pour un organe de commande tel qu'un bouton poussoir et l'ensemble de commande correspondant comportant cet organe de commande.

Afin de mieux comprendre les problèmes techniques, la description ci-dessous concerne d'abord un ensemble de commande classique tel que décrit dans le brevet antérieur EP0889956B1.

Les figures 1A et 1B représentent un tel ensemble de commande connu monté sur une paroi P1 ayant une épaisseur de 1mm.

Les figures 2A et 2B représentent un tel ensemble de commande connu monté sur une paroi P2 ayant une épaisseur de 6mm.

L'organe de commande 1 comporte typiquement une tête 11 et un corps tubulaire 12 prolongeant sa tête.

Un tel organe de commande 1 est destiné à être fixé à travers une paroi P1, P2, formée par exemple de la porte d'une armoire électrique ou d'un pupitre de commande.

La paroi P1, P2 comporte une face avant et une face arrière. La face avant est accessible à l'utilisateur pour manipuler et visualiser chaque organe de commande et/ou de signalisation et la face arrière lui est cachée.

Pour chaque organe de commande et/ou de signalisation, la paroi est percée d'une ouverture circulaire de diamètre normalisé (par exemple diamètre 22mm).

Lors du montage, le corps tubulaire 12 de l'organe est engagé à travers l'ouverture et la tête 11 vient en appui contre la face avant de la paroi, en périphérie de l'ouverture, éventuellement contre un joint de forme adaptée. La partie tubulaire s'étend à l'arrière de la paroi.

En référence aux figures 3A et 3B, un dispositif de fixation adapté assure la fixation de l'organe sur la paroi, par l'arrière. Ce dispositif de fixation comporte une embase 2 de fixation, par exemple de forme générale rectangulaire.

L'embase 2 est formée d'un corps 22 et d'une platine porte-contacts 23 assemblée audit corps par des moyens classiques.

Le corps 22 de l'embase comporte une ouverture 21 adaptée pour recevoir le corps tubulaire 12 de l'organe de commande et/ou de signalisation.

La platine porte-contacts 23 est également dotée d'une ouverture et est destinée à porter de manière amovible et après verrouillage un ou plusieurs blocs 4 de contacts électriques et/ou d'éclairage.

L'embase 2 est destinée à s'emboîter sur le corps tubulaire 12 de l'organe de commande, à l'arrière de la paroi P1, P2.

Le dispositif de fixation comporte un verrou 24 destiné à verrouiller l'assemblage de l'embase 2 sur le corps tubulaire 12 et à empêcher l'extraction de l'embase 2 dans la direction axiale.

Le verrou 24 est par exemple coulissant et comporte par exemple un étrier, un doigt de manoeuvre 25 et un ressort de verrouillage 26. L'étrier est guidé dans des glissières réalisées sur l'embase et il est soumis à une sollicitation du ressort de verrouillage 26 qui tend à le déplacer vers l'axe principal (X).

Le dispositif de fixation comporte des moyens d'appui contre la face arrière de la paroi P1, P2. Les moyens d'appui comportent une bride 3 montée pivotante sur l'embase 2.

La bride 3 se présente avantageusement sous la forme d'un étrier en U, avantageusement symétrique. Elle comporte avantageusement deux branches 33, 34 latérales reliées entre elles par un pont 37.

Les deux branches 33, 34 s'étendent à l'extérieur de l'embase 2. Le pivotement de la bride 3 par rapport à l'embase 2 est permis grâce à un mécanisme d'articulation comprenant des paliers d'articulation 35 réalisés sur l'intérieur des branches et des tourillons 27 correspondants réalisés sur le corps 22 de l'embase 2.

Le dispositif de fixation comporte également une plaquette-écrou 32 qui est montée pivotante sur la bride 3. La plaquette écrou 32 est articulée sur la bride par une articulation 36. Les débattements en rotation de la plaquette-écrou 32 sont limités par des butées ménagées dans l'articulation.

Le dispositif de fixation comporte une vis de serrage 31 type vis pointeau.

La vis de serrage 31 est guidée dans un alésage réalisé à travers le corps de l'embase 2 et s'engage par son extrémité dans la plaquette-écrou 32 de manière à se visser dans ladite plaquette 32.

De manière classique, un bloc 4 de contacts et/ou d'éclairage comporte un boîtier en matériau plastique. Un bloc de contacts comporte un poussoir et une paire de contacts de type normalement fermé ou de type normalement ouvert, actionnables par le poussoir. Un bloc d'éclairage comporte une source lumineuse destinée à l'éclairage de l'organe en face avant de la paroi.

Chaque bloc 4 de contacts et/ou d'éclairage vient se fixer sur la platine porte-contacts 23 de l'embase 2. Chaque bloc 4 est muni d'une part d'un verrou d'accrochage 41 mobile qui peut s'engager dans une gâche de la platine et d'autre part d'un doigt d'accrochage 42 fixe destiné à venir s'accrocher dans une gâche de la platine de l'embase.

Lors du montage, l'installateur engage le corps tubulaire 12 de l'organe à travers l'ouverture formée dans la paroi P1, P2 par l'avant. A l'arrière de la paroi, il emboîte l'embase 2 sur le corps tubulaire 12 jusqu'à verrouillage par le verrou. En serrant la vis 31, il assure le pivotement le la bride 3. Lors du serrage, la pointe de la vis 31 et les extrémités libres des deux branches 33, 34 d'ancrage viennent en appui contre la face arrière de la paroi P1, P2.

En référence à la figure 4, le bloc de contacts et/ou d'éclairage peut notamment présenter une architecture compacte, permettant un gain en encombrement de l'ensemble en profondeur lorsque ce bloc est assemblé sur une embase telle que décrite ci-dessus.

La figure 5 permet d'illustrer que l'emploi d'un tel bloc de contacts et/ou d'éclairage compact 400 sur un dispositif de fixation tel que décrit ci-dessus entraîne la création de lignes de fuite dans certaines zones, pouvant entraîner des courts-circuits. On distingue notamment deux zones de création de lignes de fuite :
- Une première zone Z1 entre la tête de la vis de serrage et les sorties de câble au niveau du bloc de contacts et/ou d'éclairage ;
- Une deuxième zone Z2 entre le verrou de fixation métallique de chaque bloc de contacts et/ou d'éclairage sur l'embase et les sorties de câble au niveau du bloc de contacts et/ou d'éclairage.

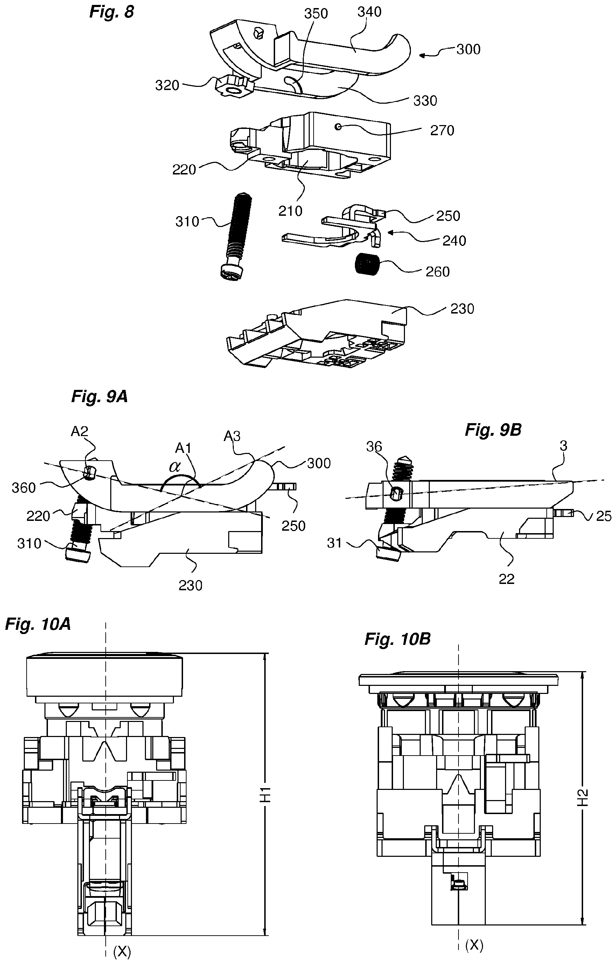

Pour remédier à ces probables lignes de fuite, l'invention consiste notamment à proposer un dispositif de fixation modifié tel que représenté sur la figure 8.

Les fonctions des différents éléments restent identiques à celles définies ci-dessus pour l'état de la technique.

Pour ce dispositif de fixation, on a ainsi les références suivantes :
- Embase 200,
- Ouverture 210,
- Corps embase 220,
- Platine porte-contacts 230,
- Verrou 240,
- Doigt de manoeuvre 250,
- Ressort 260,
- Tourillons 270,
- Bride pivotante 300,
- Plaquette-écrou 320,
- Branches 330, 340,
- Paliers d'articulation 350,
- Articulation 360,
- Vis de serrage 310,
- Bloc 400 de contacts,
- Doigt d'accrochage 420,
- Verrou d'accrochage 410.

Dans le dispositif de fixation de l'invention, le principe de fonctionnement reste identique à celui décrit ci-dessus. En revanche, dans ce dispositif, la bride pivotante 300 est configurée de manière particulière.

Pour mieux comprendre, on définit :
- Un premier axe A1 correspondant à l'axe de pivotement de la bride par rapport à l'embase ;
- Un deuxième axe A2 correspondant à l'axe formé par l'articulation en pivotement de la plaquette écrou ;
Au moins un point d'appui situé à l'extrémité libre de chaque branche de la bride pivotante, destiné à venir en appui contre la face arrière de la paroi ;
Les deux points d'appui formés sont avantageusement formés suivant un troisième axe A3 ;
Le premier axe A1, le deuxième axe A2 et le troisième axe A3 ainsi formés sont avantageusement parallèles.

Partant de là, en référence à la figure 9A, on comprend que la bride pivotante est configurée de sorte que :
- Un premier plan incluant le premier axe A1 et le deuxième axe A2 et un deuxième plan incluant le premier axe A1 et le troisième axe A3 sont sécants et forment entre eux un angle α différent de 180°, avantageusement inférieur à 160° et avantageusement compris entre 110° et 160°, avantageusement compris entre 120 et 150° et avantageusement sensiblement égal à 140°.

Autrement dit, le premier axe A1 est désaligné par rapport au plan incluant les deux autres axes.

Le sommet de l'angle est défini par les points situés sur le premier axe A1.

En désalignant le premier axe A1 par rapport aux deux autres axes, il est ainsi possible de maintenir un débattement limité de la vis 310 lors du serrage. Autrement dit, à positions de vis équivalentes, la solution de l'invention permet un meilleur serrage sur la paroi. Les figures 9A et 9B illustrent l'avantage procuré par la solution de l'invention.

Par ailleurs, en limitant le débattement de la vis 310 lors du serrage, il est ainsi possible de toujours garder la tête de vis suffisamment éloignée des sorties de câble présentes sur le bloc de contacts et/ou d'éclairage et ainsi d'éviter l'apparition de courants de fuite entre ces éléments.

En référence aux figures 8 et 9A, les deux branches 330, 340 de la bride 300 présentent ainsi chacune un profil globalement incurvé dans lequel le deuxième axe A2 et le troisième axe A3 sont situés dans un plan distinct du premier axe A1.

En outre, pour améliorer la gestion des lignes de fuite au niveau de la première zone Z1, il est également possible de jouer sur les dimensions des différents éléments de l'ensemble, notamment :
- En éloignant la vis de serrage 310 de l'axe principal (X) par un allongement de l'embase 200 ;
- En réduisant l'épaisseur de la tête 110 de l'organe de commande et/ou de signalisation et en rallongeant le corps tubulaire 120, permettant ainsi de reculer le bloc 400 de contacts et/ou d'éclairage et donc de l'éloigner de la vis de serrage 310.

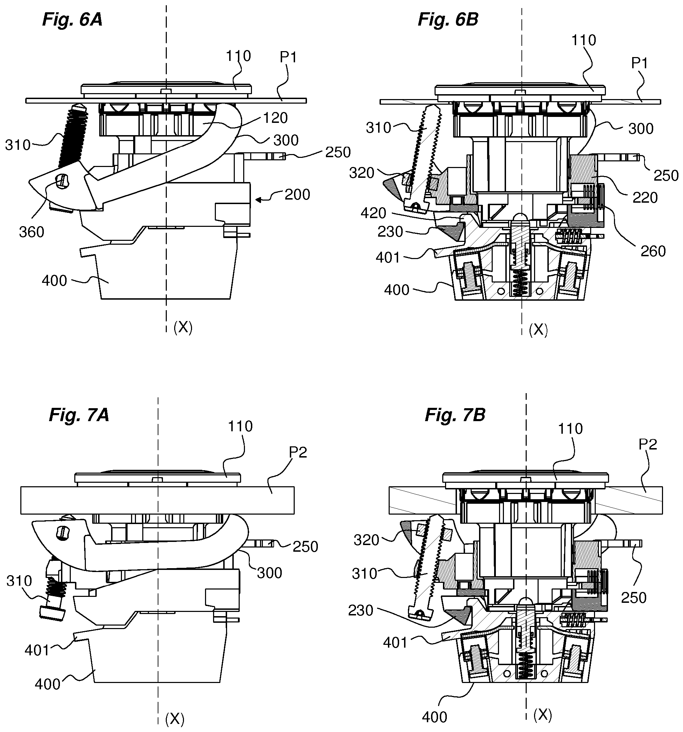

Sur les figures 6A, 6B, 7A et 7B, on peut ainsi voir que l'organe de commande et/ou de signalisation présente une tête 110 ayant une épaisseur faible, inférieure à 5mm, de manière à former un ensemble dont la tête est affleurante par rapport à la face avant de la paroi P1 ou P2.

De manière avantageuse, pour éviter la création des lignes de fuite au niveau de la deuxième zone Z2 décrite ci-dessus, la platine porte-contacts 230 est réalisée en matériau plastique. De cette manière, le verrou de fixation du bloc 400 de contacts et/ou d'éclairage sur la platine porte-contacts 230 n'est pas relié à la terre et reste à un potentiel flottant. L'épaisseur de cette platine 230 sera avantageusement d'une dimension adaptée pour éviter la création de lignes de fuite.

De manière avantageuse, il est également possible de dimensionner chaque bloc de contacts et/ou d'éclairage pour faire en sorte d'allonger les lignes de fuite.

En référence à la figure 4, il s'agit ainsi de rajouter une proéminence 401 au niveau du boîtier du bloc 400 de contacts et/ou d'éclairage pour que les lignes de fuite soient obligées de les contourner. Cette proéminence 401 est positionnée entre la sortie de câble du bloc 400 de contacts et/ou d'éclairage et le doigt d'accrochage 420 du bloc de contacts et/ou d'éclairage sur l'embase 200.

En référence aux figures 10A et 10B, on peut ainsi voir que la compacité d'un ensemble de commande peut être réduite, par exemple de 6mm en hauteur, tout en ne négligeant pas la gestion des lignes de fuite telles que définies ci-dessus. Ceci est notamment permis par l'adaptation du dispositif de fixation à ces nouvelles contraintes. Sur la figure 10A, l'ensemble de commande de l'état de la technique est d'un encombrement en hauteur H1 et l'ensemble de commande selon l'invention est d'un encombrement en hauteur H2.

## Revendications

1. Dispositif de fixation pour organe de commande et/ou de signalisation électrique destiné à être assemblé suivant un axe principal (X) à travers une ouverture réalisée dans une paroi (P1, P2) et comportant une tête (110) destinée à venir en appui contre une première face de la paroi (P1, P2) et un corps (120) tubulaire destiné à être engagée à travers l'ouverture, ledit dispositif de fixation comportant :
- une embase (200) destinée à porter au moins un bloc de contacts électriques et/ou d'éclairage,
- une bride de fixation (300) montée pivotante sur l'embase (200) autour d'un premier axe (A1),
- ladite bride (300) comportant au moins une branche dotée d'une extrémité libre destinée à former au moins un premier point d'appui contre une deuxième face de la paroi opposée à ladite première face,
- un élément articulé autour d'un deuxième axe (A2) et coopérant avec ladite bride pour l'entraîner en pivotement autour dudit premier axe (A1),
- une vis de serrage (310) guidée dans ladite embase (200) et coopérant avec ladite articulation pour contrôler le pivotement de ladite bride (300) et comprenant une extrémité formant au moins un deuxième point d'appui contre ladite deuxième face de la paroi,
**caractérisé en ce que** :
- la bride (300) est configurée de manière à ce qu'un premier plan incluant ledit premier axe (A1) et ledit deuxième axe (A2) et un deuxième plan incluant ledit premier axe (A1) et ledit premier point d'appui forment un angle (α) compris entre 110° et 160°.

2. Dispositif selon la revendication 1, **caractérisé en ce que** ledit angle (α) est compris entre 120° et 150°.

3. Dispositif selon la revendication 1 ou 2, **caractérisé en ce que** l'embase (200) comporte un corps et une platine porte-contacts (230) et **en ce que** ladite platine porte-contacts est réalisée en matériau plastique.

4. Dispositif selon l'une des revendications 1 à 3, **caractérisé en ce que** la bride (300) comporte une forme en étrier possédant deux branches (330, 340) reliées entre elles par un pont.

5. Dispositif selon la revendication 4, **caractérisé en ce que** les deux branches présentent chacune au moins un profil incurvé.

6. Dispositif selon l'une des revendications 1 à 5, **caractérisé en ce que** ledit élément articulé comporte une plaquette-écrou (320) articulée par rapport à l'embase.

7. Ensemble de commande et/ou de signalisation électrique comprenant :
- un organe de commande et/ou de signalisation électrique destiné à être assemblé suivant un axe principal (X) à travers une ouverture réalisée dans une paroi (P1, P2) et comportant une tête destinée à venir en appui contre une première face de la paroi et un corps tubulaire destiné à être engagée à travers l'ouverture,
- **caractérisé en ce qu'**il comporte :
- un dispositif de fixation tel que défini dans l'une des revendications 1 à 6.

8. Ensemble selon la revendication 7, **caractérisé en ce qu'**il comporte au moins un bloc (400) de contacts et/ou d'éclairage fixé sur l'embase (200) dudit dispositif de fixation.

9. Ensemble selon la revendication 8, **caractérisé en ce que** le bloc (400) de contacts et/ou d'éclairage comporte au moins un boîtier présentant une proéminence agencée pour assurer un allongement de la ligne de fuite entre au moins une sortie de câble dudit bloc de contacts et/ou d'éclairage et un verrou de fixation métallique dudit bloc de contacts et/ou d'éclairage sur ladite embase.

## Patentansprüche

1. Befestigungsvorrichtung für ein elektrisches Steuer- und/oder Anzeigeorgan, das dazu bestimmt ist, entlang einer Hauptachse (X) durch eine in einer Wand (P1, P2) ausgeführte Öffnung hindurch montiert zu werden, und einen Kopf (110), der dazu bestimmt ist, an einer ersten Seite der Wand (P1, P2) in Anlage zu kommen, und einen rohrförmigen Körper (120), der dazu bestimmt ist, durch die Öffnung hindurch eingeführt zu werden, umfasst, wobei die Befestigungsvorrichtung umfasst:
- einen Sockel (200), der dazu bestimmt ist, mindestens einen Block mit elektrischen Kontakten und/oder Beleuchtungsblock zu tragen,
- einen Befestigungsflansch (300), der um eine erste Achse (A1) schwenkbar an dem Sockel (200) montiert ist,
- wobei der Flansch (300) mindestens einen Schenkel aufweist, der mit einem freien Ende versehen ist, das dazu bestimmt ist, mindestens einen ersten Auflagepunkt an einer zweiten Seite der Wand, die zur ersten Seite entgegengesetzt ist, zu bilden,
- ein um eine zweite Achse (A2) angelenktes Element, das mit dem Flansch zusammenwirkt, um ihn um die erste Achse (A1) schwenkend anzutreiben,
- eine Klemmschraube (310), die in dem Sockel (200) geführt wird und mit dem Gelenk zusammenwirkt, um das Schwenken des Flansches (300) zu kontrollieren, und ein Ende aufweist, das mindestens einen zweiten Auflagepunkt an der zweiten Seite der Wand bildet,
**dadurch gekennzeichnet, dass**:
- der Flansch (300) so ausgebildet ist, dass eine erste Ebene, welche die erste Achse (A1) und die zweite Achse (A2) beinhaltet, und eine zweite Ebene, welche die erste Achse (A1) und den ersten Auflagepunkt beinhaltet, einen Winkel (α) zwischen 110° und 160° bilden.

2. Vorrichtung nach Anspruch 1, **dadurch gekennzeichnet, dass** der Winkel (α) zwischen 120° und 150° beträgt.

3. Vorrichtung nach Anspruch 1 oder 2, **dadurch gekennzeichnet, dass** der Sockel (200) einen Körper und eine Kontaktträgerplatine (230) aufweist und dass die Kontaktträgerplatine aus Kunststoff ausgeführt ist.

4. Vorrichtung nach einem der Ansprüche 1 bis 3, **dadurch gekennzeichnet, dass** der Flansch (300) die Form eines Bügels aufweist, der zwei Schenkel (330, 340) besitzt, die untereinander über eine Brücke verbunden sind.

5. Vorrichtung nach Anspruch 4, **dadurch gekennzeichnet, dass** die beiden Schenkel jeweils mindestens ein gekrümmtes Profil aufweisen.

6. Vorrichtung nach einem der Ansprüche 1 bis 5, **dadurch gekennzeichnet, dass** das angelenkte Element eine Mutter-Platte (320) aufweist, die in Bezug auf den Sockel angelenkt ist.

7. Elektrische Steuer- und/oder Anzeigeanordnung, umfassend:
- ein elektrisches Steuer- und/oder Anzeigeorgan, das dazu bestimmt ist, entlang einer Hauptachse (X) durch eine in einer Wand (P1, P2) ausgeführte Öffnung hindurch montiert zu werden, und einen Kopf, der dazu bestimmt ist, an einer ersten Seite der Wand in Anlage zu kommen, und einen rohrförmigen Körper, der dazu bestimmt ist, durch die Öffnung hindurch eingeführt zu werden, umfasst,
- **dadurch gekennzeichnet, dass** sie umfasst:
- eine Befestigungsvorrichtung nach einem der Ansprüche 1 bis 6.

8. Anordnung nach Anspruch 7, **dadurch gekennzeichnet, dass** sie mindestens einen Kontakt- und/oder Beleuchtungsblock (400) aufweist, der auf dem Sockel (200) der Befestigungsvorrichtung befestigt ist.

9. Anordnung nach Anspruch 8, **dadurch gekennzeichnet, dass** der Kontakt- und/oder Beleuchtungsblock (400) mindestens ein Gehäuse umfasst, das einen Vorsprung aufweist, der so gestaltet ist, dass er eine Verlängerung der Kriechstrecke zwischen mindestens einem Kabelausgang des Kontakt- und/oder Beleuchtungsblocks und einem metallischen Befestigungsriegel zur Befestigung des Kontakt- und/oder Beleuchtungsblocks auf dem Sockel gewährleistet.

## Claims

1. Fastening device for an electric control and/or indicator member designed to be assembled along a main axis (X) through an opening formed in a wall (P1, P2) and comprising a head (110) designed to bear against a first face of the wall (P1, P2) and a tubular body (120) designed to be engaged through the opening, said fastening device comprising:
- a base (200) designed to carry at least one electric contact and/or illumination unit,
- a fastening clamp (300) fitted pivotably on the base (200) about a first axis (A1),
- said clamp (300) comprising at least one branch having a free end designed to form at least a first bearing point against a second face of the wall, opposite said first face,
- an element hinged about a second axis (A2) and interacting with said clamp to cause it to pivot about said first axis (A1),
- a clamping screw (310) guided in said base (200) and interacting with said hinging to control the pivoting of said clamp (300) and comprising an end forming at least a second bearing point against said second face of the wall,
**characterized in that**:
- the clamp (300) is configured in such a way that a first plane including said first axis (A1) and said second axis (A2) and a second plane including said first axis (A1) and said first bearing point form an angle (α) of between 110° and 160°.

2. Device according to Claim 1, **characterized in that** said angle (α) is between 120° and 150°.

3. Device according to Claim 1 or 2, **characterized in that** the base (200) comprises a body and a contact panel (230), and **in that** said contact panel is made of plastic material.

4. Device according to any of Claims 1 to 3, **characterized in that** the clamp (300) is yoke-shaped, having two branches (330, 340) interconnected by a link.

5. Device according to Claim 4, **characterized in that** each of the two branches has at least one curved profile.

6. Device according to any of Claims 1 to 5, **characterized in that** said hinged element comprises a nut plate (320) hinged relative to the base.

7. Electric control and/or indicator assembly comprising:
- an electric control and/or indicator member designed to be assembled along a main axis (X) through an opening formed in a wall (P1, P2) and comprising a head designed to bear against a first face of the wall and a tubular body designed to be engaged through the opening,
- **characterized in that** it comprises:
- a fastening device as defined in any of Claims 1 to 6.

8. Assembly according to Claim 7, **characterized in that** it comprises at least one contact and/or illumination unit (400) fastened to the base (200) of said fastening device.

9. Assembly according to Claim 8, **characterized in that** the contact and/or illumination unit (400) comprises at least one casing having a protrusion arranged to lengthen the leakage path between at least one cable outlet of said contact and/or illumination unit and a metal lock fastening said contact and/or illumination unit to said base.
